# FASCICULE DE BREVET EUROPEEN

(11) **EP 2 438 453 B1**
(45) Date de publication et mention de la délivrance du brevet: **16.05.2018**
(21) Numéro de dépôt: 10724239.8
(22) Date de dépôt: 01.06.2010
(51) Int. Cl.: G01R 33/383, H01F 7/02

(54) **GENERATEUR DE CHAMP MAGNETIQUE ET DISPOSITIF MAGNETOCALORIQUE COMPORTANT LEDIT GENERATEUR DE CHAMP MAGNETIQUE**
MAGNETFELDGENERATOR UND MAGNETOKALORISCHE VORRICHTUNG MIT DIESEM MAGNETFELDGENERATOR
MAGNETIC FIELD GENERATOR AND MAGNETOCALORIC DEVICE COMPRISING SAID MAGNETIC FIELD GENERATOR

(30) Priorité: 02.06.2009 CH 837092009
(43) Date de publication de la demande: 11.04.2012
(73) Titulaire: Clean Cooling Systems SA, 1400 Yverdon-les-Bains (CH)
(72) Inventeur: SARI, Osmann, CH-1095 Lutry (CH); ALBER, Nathanaël, CH-2117 La Côte-aux-Fées (CH)
(74) Mandataire: Nithardt, Roland
(86) Numéro de dépôt international: PCT/CH2010/000143
(87) Numéro de publication internationale: WO 2010/139083

(56) Documents cités:
- WO-A1-2007/120057
- US-A- 4 999 600
- US-A1- 2004 093 877
- US-B1- 6 680 663

## Description

### Domaine technique

La présente invention concerne un générateur de champ magnétique comportant au moins un assemblage d'aimants permanents anisotropes agencés pour créer un flux magnétique et définissant un entrefer à l'intérieur duquel est concentré ledit flux magnétique,
- ledit assemblage comportant un premier élément et un second élément montés en regard l'un de l'autre, symétriquement par rapport à un axe perpendiculaire à l'axe transversal dudit entrefer,
- chacun desdits premier et second éléments comportant au moins trois aimants permanents, et
- ledit premier et ledit second élément dudit assemblage d'aimants étant disposés sensiblement dans un même plan et au moins partiellement entourés, respectivement par des organes de fermeture du champ magnétique.

### Technique antérieure

Afin d'obtenir de manière économique un champ magnétique important dans un espace délimité, il est connu de réaliser un assemblage d'aimants permanents. La littérature décrit de tels assemblages notamment pour une application dans le domaine de l'imagerie médicale par résonance magnétique. Dans ce domaine, l'on réalise des couronnes d'aimants permanents que l'on dispose côte à côte. Les aimants permanents utilisés présentent toutefois une structure géométrique complexe difficile à réaliser, ce qui augmente le coût de revient de l'assemblage d'aimants.

La transposition de telles structures d'aimants n'est de ce fait pas envisageab'e dans le cadre d'applications à volume plus restreint, et en particulier dans le domaine des générateurs thermiques magnétocaloriques. En effet, dans ces appareils, il est indispensable de générer un champ magnétique uniforme, intense et variable dans un entrefer correspondant sensiblement au volume d'un matériau ou élément magnétocalorique afin que le champ magnétique créé puisse successivement activer et désactiver magnétiquement un ou plusieurs matériaux magnétocaloriques alternativement introduits puis retirés de l'entrefer.

Afin d'obtenir un champ magnétique important dans un espace délimité, il est connu de réaliser un assemblage d'aimants permanents selon une structure d'Halbarch. La littérature, et particulièrement les publications "J. Lee, J.M. Kenkel and D.C. Jiles, Design of permanent-magnet field source for rotary-magnetic réfrigération systems. IEEE Trans Magn 38 5 (2002), pp. 2991-2993", "K.Halbach, Nucl.Instr.Methods, vol.169, p.1, 1980", "K.Halbach, Nucl.Instr.Methods, vol.187, p.109, 1981", "F.Bloch, O.Gugat, JC.Toussaint and G.Meunier, IEEE Trans.Magn., vol.34, p.2465, 1998", "CERN Courier, vol.43, No3, p.7, 2002" et "S.J.Lee and D.C.Jiles, IEEE Trans.Magn., vol.36, No5, p.3105, 2000", décrit de tels assemblages notamment pour une application dans le domaine de l'imagerie médicale par résonance magnétique.

Diverses structures ont été imaginées pour concentrer le flux magnétique dans une zone déterminée. Le brevet US 6,680,663 B1 décrit une construction constituée d'un assemblage de barreaux ayant des sections de prismes tronqués qui sont disposés autour d'un entrefer central. Le brevet US 4,999,600 décrit un autre assemblage d'aimants composé de segments disposés en cercle autour d'un tunnel central approximativement circulaire.

Ces structures ont des géométries complexes et les aimants permanents qui les composent sont difficiles à réaliser et extrêmement coûteux à fabriquer. Il s'agit d'installations de laboratoire qui se prêtent difficilement à une réalisation industrielle suivie. En outre, les champs magnétiques obtenus sont insuffisants pour une application en tant que générateur de champ, notamment pour une machine frigorifique du type magnétocalorique.

### Exposé de l'invention

La présente invention vise à pallier les inconvénients de l'art antérieur en proposant un dispositif générant un champ magnétique intense et uniforme, facile à réaliser et ayant un faible coût de revient.
Dans ce but, l'invention concerne un générateur de champ magnétique tel que défini dans la première revendication. Avantageusement, le générateur peut comporte plusieurs groupes d'assemblages d'aimants permanents, ces assemblages étant identiques et chaque groupe comportant un entrefer unique, chaque groupe d'assemblages d'aimants étant agencé pour créer un flux magnétique et comportant des moyens pour concentrer le flux magnétique généré par ledit groupe des assemblages d'aimants permanents à l'intérieur dudit entrefer unique.
Selon un mode de réalisation avantageux, chacun des organes de fermeture du champ magnétique desdits premier et second éléments dudit assemblage d'aimants a un profil intérieur sensiblement en arc de cercle qui correspond à la disposition en arc de cercle selon trois zones des aimants permanents desdits premier et second éléments dudit assemblage d'aimants.

De manière préférentielle, lesdits aimants permanents sont agencés, dans ledit assemblage d'aimants de telle sorte que
- dans ladite zone centrale, leur aimantation est au moins approximativement tangentielle à la surface adjacente de l'organe de fermeture du champ magnétique correspondant, et
- dans lesdites première et seconde zones latérales, leur aimantation est perpendiculaire à la surface correspondante de l'organe de fermeture du champ magnétique correspondant.

De façon particulièrement avantageuse, dans lesdites première et seconde zones latérales, l'aimantation des aimants permanents est perpendiculaire à la surface adjacente des deux pièces du concentrateur de flux magnétique correspondant.

Les aimants permanents des deux zones latérales peuvent être montés chacun sur une des pièces du concentrateur de flux magnétique correspondant.

Les pièces dudit concentrateur de flux magnétique peuvent présenter, d'une part, des faces obliques dont la forme correspond à la face des aimants permanents correspondants des deux zones latérales et, d'autre part, une partie en saillie au niveau de l'entrefer.

Selon une forme de construction particulière, à chaque premier et à chaque second élément dudit assemblage d'aimants, est respectivement associé un premier et un second organe de fermeture du champ magnétique.

Selon une autre forme de construction particulière, à chaque premier et à chaque second élément dudit assemblage d'aimants, sont respectivement associés plusieurs premiers et plusieurs seconds organes de fermeture du champ magnétique.

Selon une forme de réalisation avantageuse, en outre desdits aimants permanents en forme de parallélépipèdes rectangles, sont disposés en alternance avec ceux-ci, des aimants permanents ayant, dans le plan des axes A-A et B-B, une section trapézoïdale.

### Description sommaire des dessins

La présente invention et ses avantages apparaîtront mieux dans la description suivante de modes de réalisation donnés à titre d'exemples non limitatifs, en référence aux dessins annexés, dans lesquels:
- la figure 1 représente une vue en perspective d'une première forme de réalisation d'un générateur de champ magnétique selon l'invention,
- la figure 2 représente une vue en perspective d'une deuxième forme de réalisation d'un générateur de champ magnétique selon l'invention,
- la figure 3 est une vue en élévation qui illustre la disposition des aimants dans la réalisation de la figure 1,
- la figure 4 est une vue schématique en plan qui représente la répartition des lignes de champ dans la réalisation de la figure 1,
- la figure 5 est une vue en coupe partielle du générateur de champ magnétique représenté par la figure 2,
- la figure 6 est une vue en coupe partielle d'une variante de réalisation du générateur de champ magnétique représenté par la figure 2, et
- les figures 7A à 7C sont des vues respectivement en perspective, entière et partielle, et en élévation d'une troisième forme de réalisation du générateur de champ magnétique selon l'invention.

### Meilleures manières de réaliser l'invention

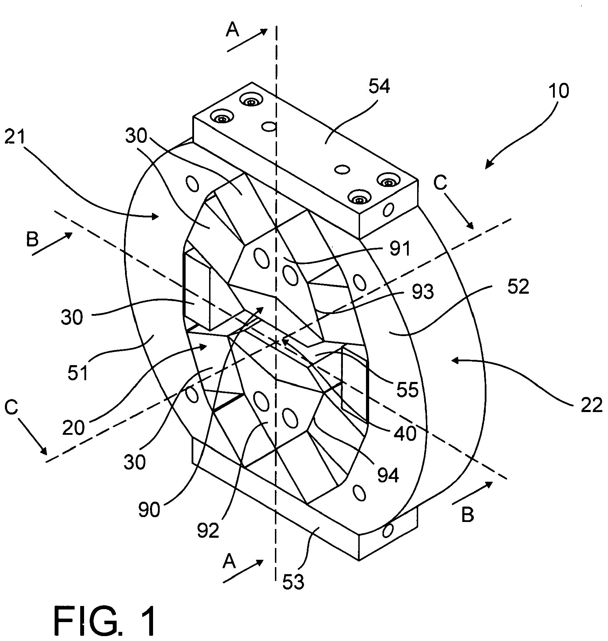

La figure 1 représente une forme de réalisation élémentaire d'un générateur de champ magnétique 10 selon l'invention. Ce générateur de champ magnétique 10 se compose dans ce cas d'un assemblage 20 d'aimants permanents 30 anisotropes agencés pour créer un flux magnétique et pour définir un entrefer 40, à l'intérieur duquel est concentré le flux magnétique. L'assemblage 20 d'aimants est constitué de deux éléments 21 et 22 montés en regard l'un de l'autre, symétriquement par rapport à un axe A-A, perpendiculaire à un axe transversal B-B de l'entrefer 40. Les éléments 21 et 22 sont identiques et sont disposés face à face. Ils comportent chacun, dans l'exemple représenté, cinq aimants permanents 30, dont le nombre pourrait varier selon les réalisations envisagées, disposés selon deux arcs de cercles opposés. Ces aimants 30 sont en forme de parallélépipèdes rectangles, de sorte qu'un espace de section sensiblement triangulaire subsiste entre deux aimants adjacents. Ces aimants permanents 30 qui forment les deux éléments 21 et 22 de l'assemblage 20 sont séparés par un concentrateur du flux magnétique 90 constitué par deux pièces 91 et 92 réalisés en un matériau ferromagnétique. Ces pièces 91 et 92 peuvent être réalisées en acier ferromagnétique, par exemple et présenter des faces obliques 93 et 94 dont la forme correspond à une face adjacente des aimants permanents 30, ces faces étant appliquées sur lesdites pièces 91 et 92 ferromagnétiques. Une boucle fermée de flux magnétique est obtenue grâce à deux organes de fermeture du champ magnétique 51 et 52, en matériau ferromagnétique entourant les aimants permanents 30 et fixées sur ces derniers par attraction magnétique. Les deux pièces de fermeture 51 et 52 sont maintenues en place par deux brides transversales 53 et 54 fixées par vissage. Les pièces de fermeture 51 et 52 peuvent en outre présenter une structure feuilletée pour augmenter leur efficacité.

La configuration du générateur de champ magnétique 10 représenté par la figure 1 permet d'utiliser des aimants permanents 30 dont la forme est aisée à réaliser. A cet effet, la forme géométrique desdits aimants permanents 30 est celle de blocs parallélépipèdes rectangles et l'aimantation dans ces derniers est anisotrope.

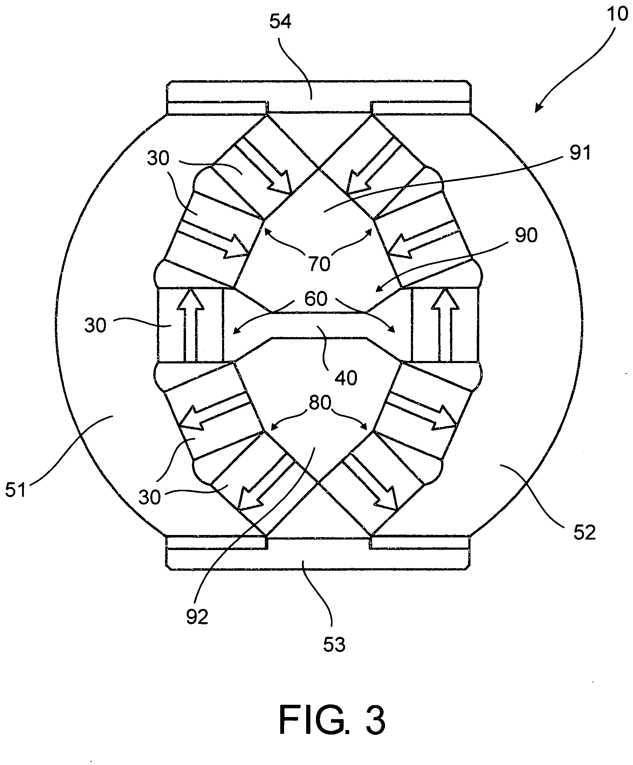

Comme le montre en particulier la figure 3, les aimants permanents 30 de l'assemblage 20 sont disposés, au niveau de chacun des deux arcs de cercle qu'ils forment, selon trois zones, à savoir une zone centrale 60 localisée en regard dudit entrefer 40 et qui comprend, dans l'exemple représenté, un seul aimant permanent 30 dont la direction d'aimantation est tangente à l'organe de fermeture du champ magnétique 51 ou 52 correspondant et deux autres zones, dites zones adjacentes 70 et 80 dont les aimants sont montés sur le concentrateur 90 du flux magnétique, plus particulièrement sur les faces obliques 93, 94 des pièces 91 et 92 ferromagnétiques qui le composent. Les aimants permanents 30 des zones adjacentes sont au nombre de deux pour chacune desdites zones, respectivement 70 et 80 pour chacun des éléments 21 et 22 de l'assemblage 20. On notera que lesdites zones adjacentes à la zone centrale 60 dites première zone latérale 70 et seconde zone latérale 80, disposées de part et d'autre des zones centrales 60, ont des directions d'aimantation opposées. Ces directions sont à la fois perpendiculaires audit concentrateur 90 et aux pièces 91 et 92 ferromagnétiques qui le composent ainsi qu'aux organes de fermeture 51 et 52 du champ magnétique.
L'espace situé entre les deux pièces 91 et 92 formant le concentrateur 90 du flux magnétique constitue l'entrefer 40 du générateur de champ magnétique 10 représenté. Pour améliorer encore la densité de flux magnétique dans cet entrefer 40, ces deux pièces 91 et 92 comportent chacune une partie en saillie 55 s'étendant dans ledit entrefer 40.

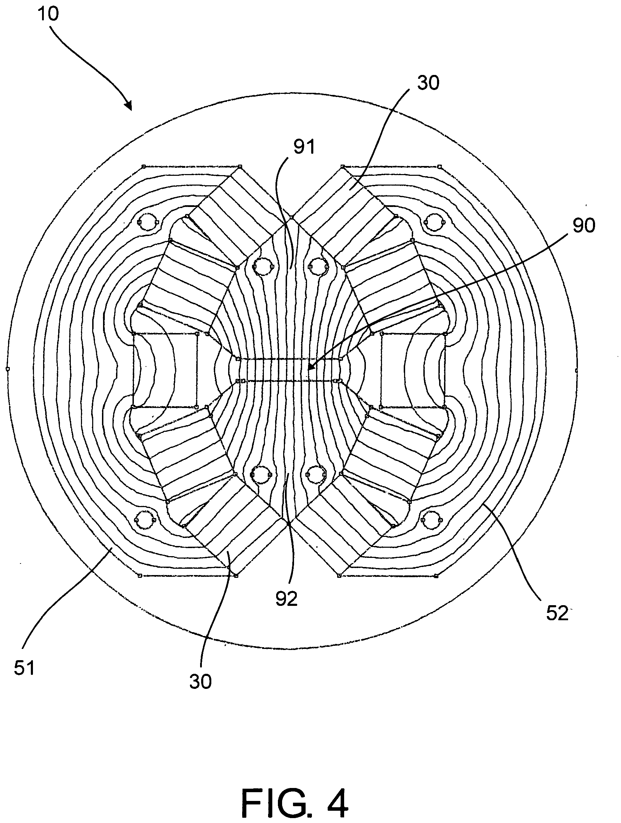

La figure 4 représente les lignes de flux magnétique dans le générateur de champ magnétique 10 de la figure 1. On constate que les lignes de flux sont concentrées au niveau de l'entrefer 40. Les organes de fermeture 51 et 52 du champ magnétique arqués et les deux pièces 91 et 92 réalisés en un matériau ferromagnétique du concentrateur du flux magnétique 90 permettent de réaliser des boucles de flux magnétique régulières, concentrées uniquement dans le volume du générateur de champ magnétique 10, qui sont prépondérantes et distribuées de manière uniforme dans l'entrefer 40. L'on obtient ainsi un générateur 10 susceptible de générer un champ intense dans son entrefer 40 malgré l'utilisation d'un nombre réduit d'aimants permanents qui ont l'avantage de présenter une structure de fabrication aisée et économique.

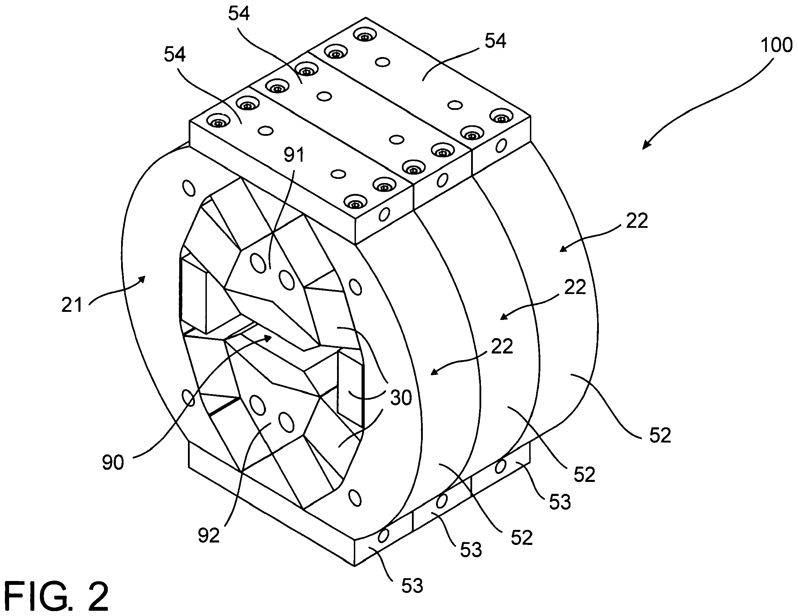

Le générateur de champ magnétique 100 représenté par la figure 2 est composé d'un ensemble d'assemblages 20 d'aimants identiques juxtaposés. Dans l'exemple représenté le nombre de ces assemblages 20 d'aimants est de trois, mais il pourrait être limité à deux ou augmenté, selon les paramètres recherchés en fonction d'une application spécifique donnée. Comme l'encombrement latéral de chaque assemblage 20 d'aimants est défini par la largeur des organes de fermeture 51 et 52 du champ magnétique, les assemblages d'aimants sont plaqués les uns aux autres et maintenus en position par un système de fixation mécanique approprié (non représenté).

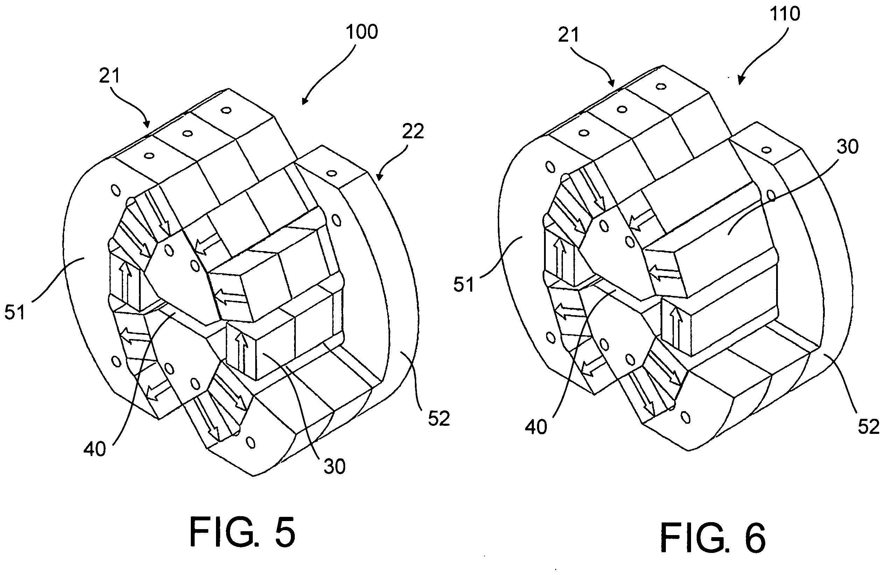

Dans les formes de réalisation représentées par les figures 1 et 2, un organe de fermeture 51, 52 est à chaque fois associé à un premier, respectivement un second élément 21, 22. Cette construction ressort plus particulièrement de la figure 5 représentant le générateur de champ magnétique 100 de la figure 2 selon une coupe partielle.

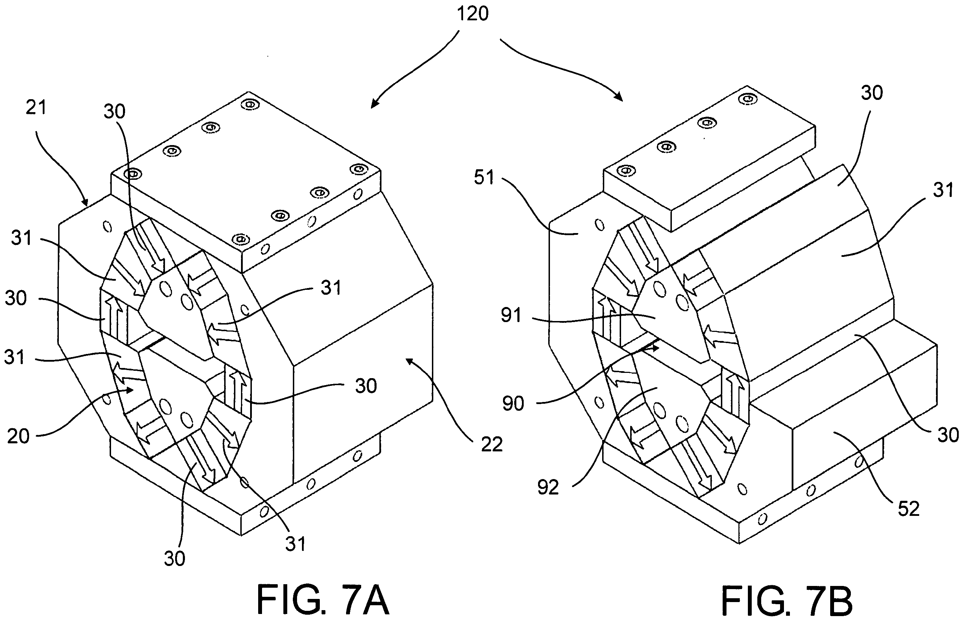

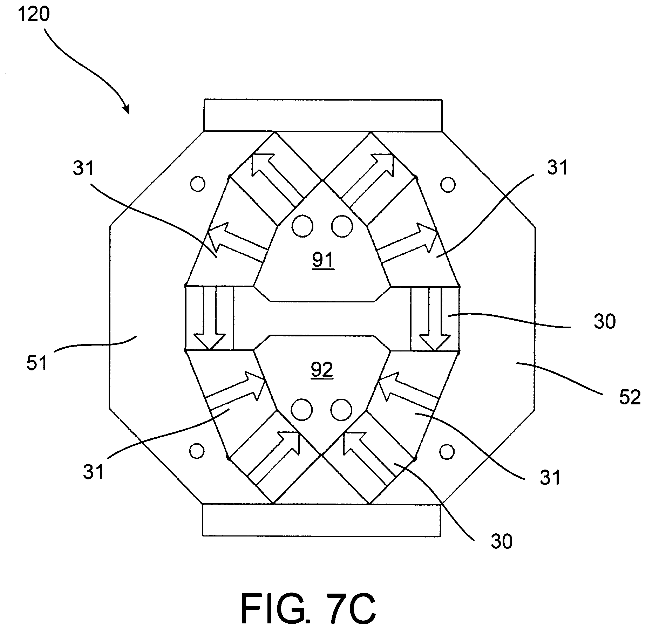

Or, il peut également être prévu d'associer plusieurs organes de fermeture 51, 52 à chaque premier ou second élément 21, 22. Dans une telle configuration, représentée par le générateur de champ magnétique 110 de la figure 6, la longueur des aimants permanents 30 (selon la direction de l'axe longitudinal C-C de l'entrefer 40) est supérieure à la largeur de chaque organe de fermeture 51, 52 pris indépendamment. L'avantage d'une telle configuration réside dans la facilité de montage. On peut également s'attendre à ce que pour une longueur donnée du générateur, cette configuration permette d'obtenir un champ magnétique plus important dans l'entrefer 40. Dans le générateur de champ magnétique 110 représenté par cette figure 6, la longueur d'un aimant permanent 30 correspond à la largeur de trois organes de fermeture 51, 52 disposés côte à côte. Ce nombre n'est toutefois pas limitatif et peut être différent selon les constructions ou selon les applications prévues.
Une troisième forme de réalisation du générateur de champ magnétique selon l'invention est représentée par les figures 7A à 7C. Comme dans le générateur de champ magnétique 10 de la figure 1, le générateur de champ magnétique 120 comporte un assemblage 20 d'aimants permanents 30, cet assemblage d'aimants étant composé de deux éléments 21 et 22 identiques disposés de manière opposée. On notera que dans les constructions décrites précédemment, les aimants permanents 30 ont une forme de blocs en forme de parallélépipèdes rectangles. Etant donné qu'ils sont disposés selon deux arcs de cercles opposés, la géométrie rectangulaire de leur section aboutit à la création d'un espace ayant sensiblement la forme d'un coin de section triangulaire entre deux aimants permanents 30 adjacents. Cet espace rempli d'air ne conduit pas les lignes de champ de façon optimale, ce qui aboutit à une perte magnétique et réduit quelque peu la puissance du champ magnétique généré. Cette forme de réalisation illustrée par les figures 7A à 7C supprime cet inconvénient en comblant l'espace entre deux blocs d'aimants permanents adjacents. C'est ainsi qu'au moins un aimant permanent 31, disposé entre deux aimants permanents 30 adjacents en forme de parallélépipèdes rectangles, présente une section trapézoïdale de manière à supprimer toutes les "ouvertures" du circuit magnétique et à créer une sorte d'anneau magnétique ininterrompu autour des pièces 91 et 92 du concentrateur de flux magnétique 90. La géométrie des organes de fermeture du champ magnétique 51 et 52 de cette forme de réalisation est en outre différente de la géométrie des réalisations représentées par les figures 1 à 6 en ce qu'elle présente une forme semi-hexagonale et non semi-cylindrique.

Les générateurs de champ magnétique 10, 100, 110 et 120 illustrés par l'ensemble des figures, sont en particulier utilisables dans un dispositif thermique magnétocalorique comportant au moins un élément magnétocalorique. Cet élément magnétocalorique peut être constitué par un ou plusieurs matériaux magnétocaloriques et est traversé par un fluide caloporteur circulant de manière alternée en direction de la première extrémité dudit générateur thermique puis en direction de sa seconde extrémité, de manière synchronisée avec un moyen d'activation et de désactivation magnétique dudit élément magnétocalorique. Ce moyen d'activation et de désactivation magnétique a pour but de soumettre de manière successive et alternée ledit élément magnétocalorique à un champ magnétique puis à un champ magnétique nul et est réalisé par le générateur de champ magnétique 10, 100, 110, 120 selon l'invention qui est mis en mouvement relatif par rapport audit élément magnétocalorique pour réaliser la variation du champ magnétique. De préférence, l'élément magnétocalorique qui est monté coulissant dans l'entrefer dudit générateur de champ magnétique est entraîné selon un déplacement de translation de va-et-vient.

### Possibilités d'application industrielle

Il ressort clairement de cette description que l'invention permet d'atteindre les buts fixés, à savoir proposer un générateur pour générer un champ magnétique dont la réalisation est structurellement simple et économique et qui permet d'obtenir un champ magnétique important avec relativement peu de matière aimantée. Un tel générateur peut notamment trouver une application aussi bien industrielle que domestique lorsqu'il est intégré dans un dispositif thermique magnétocalorique destiné à être exploité dans le domaine du chauffage, de la climatisation, du tempérage, du refroidissement ou autres, à des coûts compétitifs et avec un faible encombrement.

## Revendications

1. Générateur de champ magnétique (10; 100; 110; 120) comportant au moins un assemblage (20) d'aimants permanents (30; 31) anisotropes agencés pour créer un flux magnétique et définissant un entrefer (40) à l'intérieur duquel est concentré ledit flux magnétique,
- ledit assemblage (20) d'aimants comportant un premier élément (21) et un second élément (22) montés en regard l'un de l'autre, symétriquement par rapport à un axe (A-A) perpendiculaire à l'axe transversal (B-B) dudit entrefer (40),
- chacun desdits premier (21) et second (22) éléments comportant au moins trois aimants permanents (30; 31), et
- ledit premier (21) et ledit second (22) élément dudit assemblage (20) d'aimants étant disposés sensiblement dans un même plan, et au moins partiellement respectivement entourés par des organes de fermeture (51, 52) du champ magnétique,
lesdits aimants permanents (30) desdits premier (21) et second (22) éléments dudit assemblage (20) d'aimants étant majoritairement constitués de blocs en forme de parallélépipèdes rectangles, en ce qu'ils sont disposés sensiblement sur deux arcs de cercle opposés selon trois zones, une zone centrale (60) disposée en regard dudit entrefer (40), une première zone latérale (70), disposée d'un côté de ladite zone centrale (60) et une seconde zone latérale (80) disposée de l'autre côté de ladite zone centrale (60), lesdits aimants permanents (30) desdites première (70) et seconde (80) zones latérales ayant une direction d'aimantation opposée par rapport audit axe (A-A) perpendiculaire à l'axe transversal (B-B) dudit entrefer (40), et en ce qu'au moins deux pièces de matériau ferromagnétique (91) et (92), constituant un concentrateur de flux magnétique (90) sont disposées, de part et d'autre dudit entrefer (40), respectivement entre les aimants permanents (30) desdites premières zones latérales (70) du premier (21) et du second (22) élément de l'assemblage (20) d'aimants, disposés d'un côté de ladite zone centrale (60) et entre les aimants permanents (30) desdites secondes zones latérales (80) du premier (21) et du second (22) élément de l'assemblage (20) d'aimants, disposés de l'autre côté de ladite zone centrale (60).

2. Générateur de champ magnétique selon la revendication 1, **caractérisé en ce qu'**il comporte plusieurs groupes d'assemblages (20) d'aimants permanents (30), ces assemblages étant identiques et chaque groupe comportant un entrefer unique (40), chaque groupe d'assemblages d'aimants étant agencé pour créer un flux magnétique et comportant des moyens pour concentrer le flux magnétique généré par ledit groupe des assemblages (20) d'aimants permanents (30) à l'intérieur dudit entrefer unique (40).

3. Générateur de champ magnétique selon la revendication 1, **caractérisé en ce que** chacun des organes de fermeture (51, 52) du champ magnétique desdits premier (21) et second (22) éléments dudit assemblage (20) d'aimants a un profil intérieur sensiblement en arc de cercle qui correspond à la disposition en arc de cercle selon trois zones (60, 70, 80) des aimants permanents (30) desdits premier (21) et second (22) éléments dudit assemblage (20) d'aimants.

4. Générateur de champ magnétique selon la revendication 3, **caractérisé en ce que** lesdits aimants permanents (30) sont agencés, dans ledit assemblage (20) d'aimants, de telle sorte que
- dans ladite zone centrale (60), leur aimantation est au moins approximativement tangentielle à la surface adjacente de l'organe de fermeture (51, 52) du champ magnétique correspondant, et
- dans lesdites première et seconde zones latérales (70, 80), leur aimantation est perpendiculaire à la surface correspondante de l'organe de fermeture (51, 52) du champ magnétique correspondant.

5. Générateur de champ magnétique selon l'une quelconque des revendications précédentes, **caractérisé en ce que** dans lesdites première et seconde zones latérales (70, 80), l'aimantation des aimants permanents (30) est perpendiculaire à la surface adjacente des deux pièces de matériau ferromagnétique (91) et (92), du concentrateur de flux magnétique (90) correspondant.

6. Générateur selon l'une quelconque des revendications précédentes, **caractérisé en ce que** les aimants permanents (30) des deux zones latérales (70, 80) sont montés chacun sur une des pièces de matériau ferromagnétique (91) et (92) du concentrateur de flux magnétique (90) correspondant.

7. Générateur selon la revendication 6, **caractérisé en ce que** les pièces de matériau ferromagnétique (91) et (92) dudit concentrateur de flux magnétique (90) présentent, d'une part, des faces obliques dont la forme correspond à la face des aimants permanents (30) correspondants des deux zones latérales (70, 80) et, d'autre part, une partie en saillie (55) au niveau de l'entrefer (40).

8. Générateur selon la revendication 1, **caractérisé en ce que**, à chaque premier (21) et à chaque second (22) élément dudit assemblage (20) d'aimants est respectivement associé un premier (51) et un second (52) organe de fermeture du champ magnétique.

9. Générateur selon la revendication 1, **caractérisé en ce que**, à chaque premier (21) et à chaque second (22) élément dudit assemblage (20), sont respectivement associés plusieurs premiers (51) et plusieurs seconds (52) organes de fermeture du champ magnétique.

10. Générateur selon l'une quelconque des revendications précédentes, **caractérisé en ce qu'**en outre desdits aimants permanents en forme de parallélépipèdes rectangles, sont disposés en alternance avec ceux-ci, des aimants permanents ayant, dans le plan des axes A-A et B-B, une section trapézoïdale.

## Patentansprüche

1. Magnetfeldgenerator (10; 100; 110; 120), umfassend mindestens eine Anordnung (20) von anisotropen Dauermagneten (30; 31), die eingerichtet sind, um einen Magnetfluss zu erstellen, und einen Luftspalt (40) definieren, in dem der Magnetfluss konzentriert ist,
- wobei die Magnetanordnung (20) ein erstes Element (21) und ein zweites Element (22) umfasst, die sich im Verhältnis zu einer Achse (A-A), die zur Querachse (B-B) des Luftspalts (40) rechtwinklig ist, symmetrisch gegenüberliegend montiert sind,
- wobei jedes der ersten (21) und zweiten (22) Elemente mindestens drei Dauermagneten (30; 31) umfasst, und
- das erste (21) und das zweite (22) Element der Magnetanordnung (20) im Wesentlichen in einer Ebene angeordnet sind und mindestens teilweise jeweils von Schließelementen (51, 52) des Magnetfelds umgeben sind,
wobei die Dauermagneten (30) der ersten (21) und zweiten (22) Elemente der Magnetanordnung (20) hauptsächlich aus quaderförmigen Blöcken bestehen, im Wesentlichen auf zwei Kreisbögen angeordnet sind, die in drei Zonen entgegengesetzt sind, einer mittleren Zone (60), die gegenüber dem Luftspalt (40) angeordnet ist, einer ersten seitlichen Zone (70), die auf einer Seite der mittleren Zone (60) angeordnet ist, und einer zweiten seitlichen Zone (80), die auf der anderen Seite der mittleren Zone (60) angeordnet ist, wobei die Dauermagneten (30) der ersten (70) und zweiten (80) seitlichen Zonen eine Magnetisierungsrichtung aufweisen, die im Verhältnis zu der Achse (A-A), die zur Querachse (B-B) des Luftspalts (40) rechtwinklig ist, entgegengesetzt ist, und mindestens zwei Teile aus einem ferromagnetischen Material (91) und (92), die einen Magnetflusskonzentrator (90) bilden, auf beiden Seiten des Luftspalts (40) jeweils zwischen den Dauermagneten (30) der ersten seitlichen Zonen (70) des ersten (21) und des zweiten (22) Elements der Magnetanordnung angeordnet sind, die auf einer Seite der mittleren Zone und zwischen den Dauermagneten (30) der zweiten seitlichen Zonen (80) des ersten (21) und des zweiten (22) Elements der Magnetanordnung (20) angeordnet sind, die auf der anderen Seite der mittleren Zone (60) angeordnet sind.

2. Magnetfeldgenerator nach Anspruch 1, **dadurch gekennzeichnet, dass** er mehrere Gruppen von Anordnungen (20) von Dauermagneten (30) umfasst, wobei diese Anordnungen identisch sind und jede Gruppe einen einzigen Luftspalt (40) umfasst, wobei jede Magnetanordnungsgruppe eingerichtet ist, um einen Magnetfluss zu erstellen, und Mittel umfasst, um den Magnetfluss, der durch die Gruppe von Anordnungen (20) von Dauermagneten (20) generiert wird, in dem einzigen Luftspalt (40) zu konzentrieren.

3. Magnetfeldgenerator nach Anspruch 1, **dadurch gekennzeichnet, dass** jedes der Schließelemente (51, 52) des Magnetfelds der ersten (21) und zweiten (22) Elemente der Magnetanordnung (20) ein im Wesentlichen kreisbogenförmiges Innenprofil aufweist, das der Kreisbogenanordnung in drei Zonen (60, 70, 80) der Dauermagneten (30) der ersten (21) und zweiten (22) Elemente der Magnetanordnung (20) entspricht.

4. Magnetfeldgenerator nach Anspruch 3, **dadurch gekennzeichnet, dass** die Dauermagneten (30) in der Magnetanordnung (20) derart angeordnet sind, dass
- in der mittleren Zone (60) ihre Magnetisierung mindestens ungefähr tangential zu der angrenzenden Oberfläche des Schließelements (51, 52) des entsprechenden Magnetfelds ist, und
- in den ersten und zweiten seitlichen Zonen (70, 80) ihre Magnetisierung zu der entsprechenden Oberfläche des Schließelements (51, 52) des entsprechenden Magnetfelds rechtwinklig ist.

5. Magnetfeldgenerator nach einem der vorhergehenden Ansprüche, **dadurch gekennzeichnet, dass** in den ersten und zweiten seitlichen Zonen (70, 80) die Magnetisierung der Dauermagneten (30) zu der angrenzenden Oberfläche der beiden Teile aus ferromagnetischem Material (91) und (92) des entsprechenden Magnetflusskonzentrators (90) rechtwinklig ist.

6. Generator nach einem der vorhergehenden Ansprüche, **dadurch gekennzeichnet, dass** die Dauermagneten (30) der beiden seitlichen Zonen (70, 80) jeweils auf einem der Teile aus ferromagnetischem Material (91) und (92) des entsprechenden Magnetflusskonzentrators (90) montiert sind.

7. Generator nach Anspruch 6, **dadurch gekennzeichnet, dass** die Teile aus ferromagnetischem Material (91) und (92) des Magnetflusskonzentrators (90) einerseits schräge Seiten, deren Form der Seite der entsprechenden Dauermagneten (30) der beiden seitlichen Zonen (70, 80) entspricht, und andererseits einen vorstehenden Teil (55) am Luftspalt (40) aufweisen.

8. Generator nach Anspruch 1, **dadurch gekennzeichnet, dass** mit jedem ersten (21) und jedem zweiten (22) Element der Magnetanordnung (20) jeweils ein erstes (51) und ein zweites (52) Schließelement des Magnetfelds verknüpft ist.

9. Generator nach Anspruch 1, **dadurch gekennzeichnet, dass** mit jedem ersten (21) und mit jedem zweiten (22) Element der Anordnung (20) jeweils mehrere erste (51) und mehrere zweite (52) Schließelemente des Magnetfelds verknüpft sind.

10. Generator nach einem der vorhergehenden Ansprüche, **dadurch gekennzeichnet, dass** zusätzlich zu den quaderförmigen Dauermagneten abwechselnd damit Dauermagneten angeordnet sind, die in der Ebene der Achsen A-A und B-B einen trapezförmigen Querschnitt aufweisen.

## Claims

1. Magnetic field generator (10; 100; 110; 120) comprising at least one assembly (20) of anisotropic permanent magnets (30; 31) arranged to create a magnetic flux and defining an air gap (40) inside which the said magnetic flux is concentrated,
- the said assembly (20) of magnets comprising a first element (21) and a second element (22) mounted facing one another, symmetrically with respect to an axis (A-A) perpendicular to the transverse axis (B-B) of the said air gap (40),
- each of the said first (21) and second (22) elements comprising at least three permanent magnets (30; 31), and
- the said first (21) and the said second (22) element of the said assembly (20) of magnets being arranged substantially in one and the same plane, and at least partially respectively surrounded by magnetic field closure members (51, 52),
the said permanent magnets (30) of the said first (21) and second (22) elements of the said assembly (20) of magnets being for the most part made up of blocks in the form of rectangular parallelepipeds, in that they are arranged substantially over two opposite circular arcs in three regions, a central region (60) arranged facing the said air gap (40), a first lateral region (70) arranged on one side of the said central region (60), and a second lateral region (80) arranged on the other side of the said central region (60), the said permanent magnets (30) of the said first (70) and second (80) lateral regions having an opposite magnetization direction with respect to the said axis (A-A) perpendicular to the transverse axis (B-B) of the said air gap (40), and in that at least two pieces of ferromagnetic material (91) and (92), constituting a magnetic flux concentrator (90), are arranged, on either side of the said air gap (40), respectively between the permanent magnets (30) of the said first lateral regions (70) of the first (21) and the second (22) element of the assembly (20) of magnets, which are arranged on one side of the said central region (60), and between the permanent magnets (30) of the said second lateral regions (80) of the first (21) and the second (22) element of the assembly (20) of magnets, which are arranged on the other side of the said central region (60).

2. Magnetic field generator according to Claim 1, **characterized in that** it comprises a plurality of groups of assemblies (20) of permanent magnets (30), these assemblies being identical and each group comprising a single air gap (40), each group of assemblies of magnets being arranged to create a magnetic flux and comprising means for concentrating the magnetic flux generated by the said group of assemblies (20) of permanent magnets (30) inside the said single air gap (40).

3. Magnetic field generator according to Claim 1, **characterized in that** each of the magnetic field closure members (51, 52) of the said first (21) and second (22) elements of the said assembly (20) of magnets has a substantially circular arc-shaped inner profile which corresponds to the circular arc arrangement in three regions (60, 70, 80) of the permanent magnets (30) of the said first (21) and second (22) elements of the said assembly (20) of magnets.

4. Magnetic field generator according to Claim 3, **characterized in that** the said permanent magnets (30) are arranged, in the said assembly (20) of magnets, such that
- in the said central region (60), their magnetization is at least approximately tangential to the adjacent surface of the corresponding magnetic field closure member (51, 52), and
- in the said first and second lateral regions (70, 80), their magnetization is perpendicular to the corresponding surface of the corresponding magnetic field closure member (51, 52).

5. Magnetic field generator according to any one of the preceding claims, **characterized in that**, in the said first and second lateral regions (70, 80), the magnetization of the permanent magnets (30) is perpendicular to the adjacent surface of the two pieces of ferromagnetic material (91) and (92) of the corresponding magnetic flux concentrator (90).

6. Generator according to any one of the preceding claims, **characterized in that** the permanent magnets (30) of the two lateral regions (70, 80) are each mounted on one of the pieces of ferromagnetic material (91) and (92) of the corresponding magnetic flux concentrator (90).

7. Generator according to Claim 6, **characterized in that** the pieces of ferromagnetic material (91) and (92) of the said magnetic flux concentrator (90) have, on the one hand, oblique faces of which the shape corresponds to the face of the corresponding permanent magnets (30) of the two lateral regions (70, 80) and, on the other hand, a projecting portion (55) at the air gap (40).

8. Generator according to Claim 1, **characterized in that** each first (21) and each second (22) element of the said assembly (20) of magnets are respectively assigned a first (51) and a second (52) magnetic field closure member.

9. Generator according to Claim 1, **characterized in that** each first (21) and each second (22) element of the said assembly (20) are respectively assigned a plurality of first (51) and a plurality of second (52) magnetic field closure members.

10. Generator according to any one of the preceding claims, **characterized in that**, in addition to the said permanent magnets in the form of rectangular parallelepipeds, there are arranged in alternating fashion therewith permanent magnets having a trapezoidal cross section in the plane of the axes A-A and B-B.
